# EUROPEAN PATENT APPLICATION

(11) **EP 4 836 636 A1**
(43) Date of publication of application: **04.11.2026**
(21) Application number: 25203278.4
(22) Date of filing: 19.09.2025
(51) Int. Cl.: H10F 10/165, H10F 77/14

(54) **SOLAR CELL AND PHOTOVOLTAIC MODULE**

(30) Priority: 28.04.2025 CN 202510542032
(71) Applicant: Tongwei Solar (Chengdu) Co., Ltd., Chengdu, Sichuan 610299 (CN)
(72) Inventor: YANG, Yi, Sichuan 610299 (CN); GAN, Qin, Sichuan 610299 (CN); MENG, Xiajie, Sichuan 610299 (CN)
(74) Representative: Zacco Denmark A/S

(57) **Abstract**

The present disclosure provides a solar cell and a photovoltaic module. The solar cell includes a silicon substrate (1) having a back side including a P-type doped region (20) and an N-type doped region (30) alternately arranged. The P-type doped region (20) corresponds to a P-type doped layer (2), and the N-type doped region (30) corresponds to an N-type doped layer (3). An isolation channel (4) is disposed between the P-type doped region (20) and the N-type doped region (30) adjacent to each other. A bottom surface of the isolation channel (4) is provided with a first textured structure (5). A height difference between the P-type doped layer (2) and the first textured structure (5) is defined as *H₁,* a height difference between the N-type doped layer (3) and the first textured structure (5) is defined as *H₂,* and *H1>H2.* A sidewall (9) of the isolation channel (4) adjacent to the P-type doped region (20) is provided with at least two reflective branches (81, 82).

## Description

### TECHNICAL FIELD

The present disclosure relates to the field of solar cells, particularly relates to a solar cell and a photovoltaic module.

### BACKGROUND

Solar cells, which are devices that convert solar energy into electrical energy and have advantages of clean and pollution-free, have been widely applied in the power generation industry.

Among them, the back contact (BC) solar cell is a type of solar cell provided with no metal grid lines on its front side and with interdigitated metal fingers and busbars in the PIN region on its back side. How to modify the BC solar cell to reduce its electrical leakage and enhance its light utilization efficiency to increase the photoelectric conversion efficiency of the BC solar cell has become an urgent technical issue that needs to be solved.

### SUMMARY

To solve the above technical issue, the present disclosure provides a solar cell and a photovoltaic module, which can reduce the electrical leakage of the BC solar cell while improving the light utilization, thereby improving the photoelectric conversion efficiency of the BC solar cell.

In a first aspect, the present disclosure provides a solar cell including a silicon substrate. A back side of the silicon substrate includes a P-type doped region and an N-type doped region that are alternately arranged. The P-type doped region corresponds to a P-type doped layer disposed on the back side of the silicon substrate, and the N-type doped region corresponds to an N-type doped layer disposed on the back side of the silicon substrate. An isolation channel is disposed between the P-type doped region and the N-type doped region adjacent to each other. A bottom surface of the isolation channel is provided with a first textured structure.

A height difference between the P-type doped layer and the first textured structure is defined as *H₁*, a height difference between the N-type doped layer and the first textured structure is defined as *H₂*, and *H₁>H₂.*

A sidewall of the isolation channel adjacent to the P-type doped region is provided with at least two reflective branches.

In some embodiments of the present disclosure, 1.5 µm ≤ *H₂ ≤* 5 µm, and 1.5 ≤ *H₁*/*H₂* ≤ 3.5.

In some embodiments of the present disclosure, the at least two reflective branches include a first reflective branch and a second reflective branch, and both the first reflective branch and the second reflective branch are located on a sidewall of the isolation channel adjacent to the P-type doped region.

In some embodiments of the present disclosure, a height difference between the second reflective branch and the first reflective branch is defined as *H₃*, and 1.5 µm ≤*H₃* ≤ 3 µm.

In some embodiments of the present disclosure, a length of the first reflective branch is defined as *L₁*, a length of the second reflective branch is defined as *L₂* and *L₁ < L₂.*

In some embodiments of the present disclosure, 0.5 µm ≤ *L₁* ≤ 1 µm, and 1 µm ≤ *L₂* ≤ 2 µm.

In some embodiments of the present disclosure, the sidewall of the isolation channel adjacent to the P-type doping region is inclined towards the P-type doping region at an angle range of 40° to 60°.

In a second aspect, the present disclosure provides a photovoltaic module, which includes the solar cell as described in the first aspect.

Compared to the prior art, the present disclosure has at least the following beneficial effects:

The present disclosure provides a solar cell and a photovoltaic module. The solar cell includes a silicon substrate. A back side of the silicon substrate includes a P-type doped region and an N-type doped region that are alternately arranged. The P-type doped region corresponds to a P-type doped layer disposed on the back side of the silicon substrate, and the N-type doped region corresponds to an N-type doped layer disposed on the back side of the silicon substrate. An isolation channel is disposed between the P-type doped region and the N-type doped region adjacent to each other. A bottom surface of the isolation channel is provided with a first textured structure. A height difference between the P-type doped layer and the first textured structure is defined as *H₁*, a height difference between the N-type doped layer and the first textured structure is defined as *H₂*, and *H₁ > H₂*, which can reduce the undesirable phenomena such as electrical leakage. A sidewall of the isolation channel adjacent to the P-type doped region is provided with at least two reflective branches. The reflective branches are configured to redirect light from the isolation channel back into the silicon substrate to increase the light utilization on the back side of the solar cell. The solar cell with the structure of the present disclosure can reduce the electrical leakage of the BC solar cell while improving its light utilization, thereby achieving increased photoelectric conversion efficiency.

### BRIEF DESCRIPTION OF THE DRAWINGS

FIG. 1 is a schematic structural view of a solar cell according to an embodiment of the present disclosure;
FIG. 2 is a scanning electron microscope (SEM) image showing a morphology of the solar cell according an embodiment of the present disclosure;
FIG. 3 a SEM image showing the morphology of the solar cell from another perspective according to an embodiment of the present disclosure;
FIG. 4 is a partial schematic view of the solar cell according to an embodiment of the present disclosure;
FIG. 5 is a schematic structural view of a solar cell according to another embodiment of the present disclosure;
FIG. 6 is a schematic structural view of a half-finished solar cell obtained after a first depositing treatment of the present disclosure;
FIG. 7 is a schematic structural view of a half-finished solar cell obtained after a first patterning treatment of the present disclosure;
FIG. 8 is a schematic structural view of a half-finished solar cell obtained after a second polishing treatment of the present disclosure;
FIG. 9 is a schematic structural view of a half-finished solar cell obtained after a second depositing treatment of the present disclosure;
FIG. 10 is a schematic structural view of a half-finished solar cell obtained after the second patterning treatment of the present disclosure;
FIG. 11 is a schematic structural view of a solar cell according to yet another embodiment of the present disclosure.

Reference numerals:
silicon substrate-1, P-type doped region-20, N-type doped region-30, P-type doped layer-2, N-type doped layer-3, isolation channel-4, first textured structure-5, first dielectric layer-6, second dielectric layer-7, reflective branch-8, sidewall-9, first passivation layer-10, first anti-reflection layer-11, second passivation layer-12, second anti-reflection layer-13, electrode grid line-14, first silicon oxide mask layer-21, patterned region-22, second silicon oxide mask layer-31, micro-unit structure-51, first reflective branch-81, second reflective branch-82.

### DETAILED DESCRIPTION

In the present disclosure, the orientation or position relationships indicated by the terms "on", "below", "left", "right", "front", "back", "top", "bottom", "inner", "outer", "vertical", "horizontal", "transverse", "longitudinal", and the like are based on the orientation or position relationships shown in the accompanying drawings, and are intended to describe the present disclosure and the embodiments thereof better, rather than defining that the apparatus, element or component referred to must have a particular orientation or be constructed and operated in a particular orientation.

Furthermore, in addition to indicating orientation or positional relationships, some of the aforementioned terms can also be used to express other meanings. For example, the term "on" may in some cases be used to denote a certain attachment or connection relationship. The specific meanings of these terms in the present disclosure can be understood based on specific circumstances by those of ordinary skills in the art.

In addition, the terms such as "mount", "dispose", "arrange", "connect ", and "couple" should be interpreted in a broad sense. For example, they may be a fixed connection or a detachable connection or an integral connection; may refer to a mechanical connection or an electrical connection, and may refer to a direct connection, an indirect connection via an intermediate medium, an internal communication between two devices, elements, or components. The specific meanings of these terms in the present disclosure can be understood based on specific circumstances by those of ordinary skills in the art.

Additionally, the terms "first", "second", etc. are mainly used to distinguish different devices, elements, or components, specific types and structures of which may be the same or different, and the terms are not intended to indicate or imply the relative importance or quantity of the indicated devices, elements, or components. Unless otherwise specified, "a plurality of" means two or more.

The technical solutions of the present disclosure will be further described below in conjunction with the embodiments and accompanying drawings.

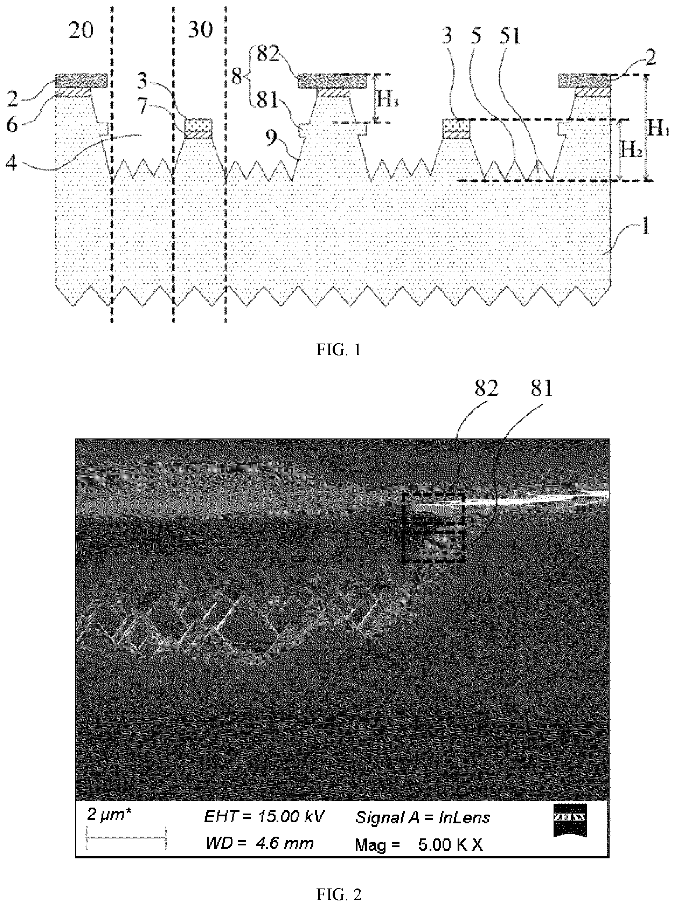

The present disclosure provides a solar cell. FIG. 1 is a schematic structural view of a solar cell according to an embodiment of the present disclosure. As shown in FIG. 1, the solar cell includes a silicon substrate 1. A back side of the silicon substrate 1 includes a P-type doped region 20 and an N-type doped region 30 that are alternately arranged. The P-type doped region 20 corresponds to a P-type doped layer 2 disposed on the back side of the silicon substrate 1, and the N-type doped region 30 corresponds to an N-type doped layer 3 disposed on the back side of the silicon substrate 1. An isolation channel 4 is disposed between the P-type doped region 20 and the N-type doped region 30 adjacent to each other. A bottom surface of the isolation channel 4 is provided with a first textured structure 5. A height difference between the P-type doped layer 2 and the first textured structure 5 is defined as *H₁*, a height difference between the N-type doped layer 3 and the first textured structure 5 is defined as *H₂*, and *H₁* > *H₂.* A sidewall 9 of the isolation channel 4 adjacent to the P-type doping region 20 is provided with at least two reflective branches 8. In addition, the back side of the silicon substrate 1 is provided with a first dielectric layer 6 in the P-type doped region 20. The P-type doped layer 2 is disposed on a surface of the first dielectric layer 6 facing away from the silicon substrate 1. The back side of the silicon substrate 1 is provided with a second dielectric layer 7 in the N-type doped region 30. The N-type doped layer 3 is disposed on a surface of the second dielectric layer 7 facing away from the silicon substrate 1.

In the present disclosure, referring to FIG. 1, the first textured structure 5 can be formed by a plurality of pyramid-like microscopic structures 51. The pyramid-like microscopic structures 51 can be formed in a texturing process of a back side of the solar cell. In the present disclosure, the height difference *H₁* between the P-type doped layer and the first textured structure refers to a distance between a top part of the P-type doped layer and a bottom part of the first textured structure; and the height difference *H₂* between the N-type doped layer and the first textured structure refers to a distance between a top part of the N-type doped layer and the bottom part of the first textured structure.

In the present disclosure, undesirable phenomena such as electrical leakage can be reduced by controlling *H₁*>*H₂.* This is because in the manufacturing process of the BC solar cell in the present disclosure, the P-type doped layer is firstly formed, and then the N-type doped region is obtained through a first patterning treatment and an alkaline solution polishing, with the N-type doped region 22 being etched by the alkaline solution down to the silicon substrate, effectively isolating the P-type doped region from the N-type doped region on the back side. Additionally, the adjacent side of the P-type doped region to the isolation channel is provided with at least two reflective branches configured to redirect light from the isolation channel back into the silicon substrate to increase the light utilization on the back side of the solar cell. The solar cell with the structure of the present disclosure can reduce the electrical leakage of the BC solar cell while improving its light utilization, thereby achieving increased photoelectric conversion efficiency.

Embodiments of the first dielectric layer and/or the second dielectric layer can be made of a material selected from various dielectric materials, such as silicon oxide, magnesium fluoride, amorphous silicon, polysilicon, silicon carbide, silicon nitride, silicon oxynitride, aluminum oxide, titanium oxide, and any combinations thereof. In an embodiment, the first dielectric layer and/or the second dielectric layer can be composed of a silicon oxide layer containing silicon oxide. The silicon oxide layer has an excellent passivation performance, and can minimize recombination loss of minority carriers on the surface of the semiconductor substrate. In addition, the silicon oxide layer is a thin film with an excellent reliability for subsequent high-temperature process. In order to provide better interfacial passivation for the substrate, the first dielectric layer and/or the second dielectric layer can have a thickness of 0.1 nm to 5 nm. For example, the first dielectric layer and/or the second dielectric layer can have a thickness of 0.1 nm, 0.5 nm, 1 nm, 1.5 nm, 2 nm, 3 nm, 4 nm, 5 nm, etc. However, the present disclosure is not limited thereto, and the thickness of the first dielectric layer and/or the second dielectric layer can have various numeric values. The first dielectric layer or the second dielectric layer, as a barrier for electrons and holes, can prevent the passing-through of minority carriers in combination with the polysilicon layer. The first dielectric layer or the second dielectric layer can also have the function of a pinhole channel, allowing the carriers in the solar cell to move freely, and a selective passing-through for majority carriers can be achieved by the heavily doped polysilicon, which is beneficial for reducing the recombination loss of minority carriers. Additionally, the first dielectric layer or the second dielectric layer can serve as a diffusion barrier to prevent the dopant in the doped polysilicon layer from diffusing into the semiconductor substrate.

The silicon substrate in the present disclosure has a thickness of 100 µm to 200 µm, which is not specifically limited in the present disclosure.

In some embodiments of the present disclosure, 1.5 µm ≤ *H₂* ≤ 5 µm, and 1.5 ≤ *H₁*/*H₂* ≤ 3.5. For example, *H₂* is 1.5 µm, 2 µm, 3 µm, 4 µm, or 5 µm, and *H₁*/*H₂* is 1.5, 2, 2.5, 3, or 3.5. The inventors have found through researches that that if *H₂* is too small (e.g., less than 1.5 µm), polishing-solution residues would remain in the N-type doped region and the isolation channel, which can lead to a conduction with the P-type doped region, resulting in relatively large electrical leakage in the solar cell. If *H₂* is too large (e.g., greater than 5 µm), the depth of the N-type doped region and the isolation channel would be too large, which is necessary to increase a corrosion of the alkaline solution, resulting in corrosion and damage to the film/layer structure in the N-type doped region. If *H₁*/*H₂* is too small (e.g., less than 1.5), the silicon oxide layer, the doped polysilicon layer, and the inner diffused layer that are formed during the doping would be not completely removed, failing to ensure good isolation effect and potentially leading to increased electrical leakage. If *H₁*/*H₂* is too large (e.g., greater than 3.5), the subsequent electrode paste printing would become difficult, affecting the printing quality of the electrode grid lines. By controlling *H₂* and *H₁*/*H₂* within the ranges specified in the present disclosure, it is beneficial for reducing the electrical leakage while enhancing the printing quality of the electrode grid lines.

In some embodiments of the present disclosure, referring to FIG. 1, the at least two reflective branches 8 include a first reflective branch 81 and a second reflective branch 82. Both the first reflective branch 81 and the second reflective branch 82 are disposed onto the sidewall 9 of the isolation channel 4 adjacent to the P-type doped region. Due to the combined reflection effect of the first reflective branch and the second reflective branch, part of light reflected from the back side of the silicon substrate can be redirected back into the silicon substrate and be absorbed and utilized by the silicon substrate, thereby improving the utilization rate of light on the back side of the solar cell and then enhancing the photovoltaic conversion efficiency.

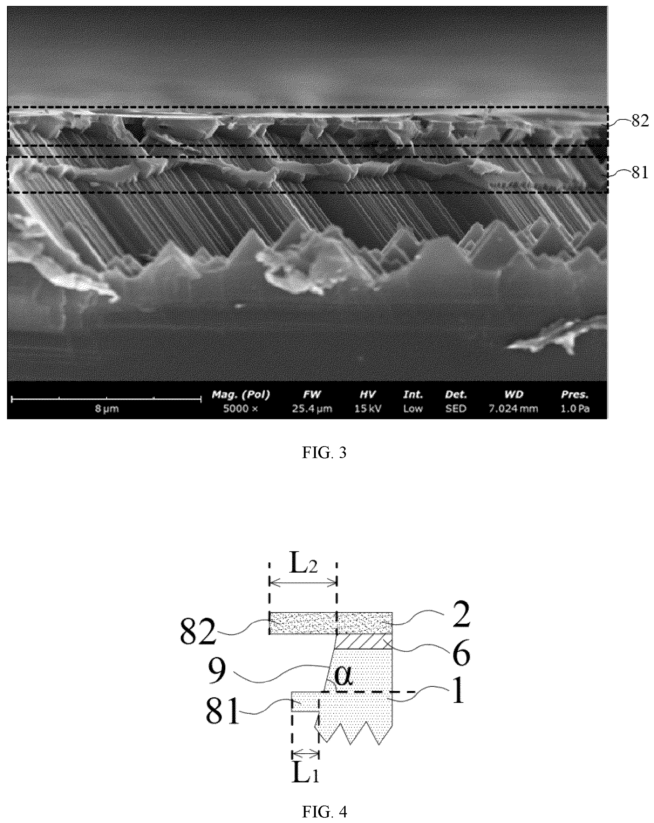

FIG. 2 is a SEM image showing a morphology of a solar cell according to an embodiment of the present disclosure. FIG. 3 is a SEM image showing the morphology of the solar cell from another perspective according to an embodiment of the present disclosure. As shown in the black dotted blocks in FIG. 2 and FIG. 3, the reflective branch of the present disclosure includes a first reflective branch 81 and a second reflective branch 82. The first reflective branch 81 and the second reflective branch 82 are each protruded from the sidewall of the isolation channel adjacent to the P-type doped region. It can also be seen from FIG. 2 and FIG. 3 that the back side of the silicon substrate of the present disclosure has a first textured structure formed by a plurality of pyramid-like microscopic structures.

In some embodiments of the present disclosure, referring to FIG. 1, the second reflective branch 82 is located at a height higher than that of the first reflective branch 81. In the present disclosure, the reference baseline for the heights at which the second reflective branch and the first reflective branch are located is established at the bottom of the first textured structure 5. By controlling the second reflective branch to be located at a height higher than that of the first reflective branch, an effective interval distance can be maintained between the first reflective branch and the second reflective branch, thereby better accommodating the requirements for multiple reflections and utilizations of incident light.

In some embodiments of the present disclosure, referring to FIG. 1, a height difference between the second reflective branch and the first reflective branch is defined as *H₃*, where 1.5 µm ≤ *H₃ ≤* 3 µm. For example, *H₃* is 1.5 µm, 1.8 µm, 2.0 µm, 2.5 µm, or 3 µm. By controlling *H₃* within the above range, part of light reflected from the back side of the silicon substrate can be redirected back into the silicon substrate and being absorbed and utilized by the silicon substrate due to the reflex action of the first reflective branch and the second reflective branch, thereby achieving multiple utilizations of light.

In some embodiments of the present disclosure, referring to FIG. 4 which is a partial schematic view of the solar cell according to an embodiment of the present disclosure, a length of the first reflective branch 81 is defined as *L₁*, and a length of the second reflective branch 82 is defined as *L₂*, where *L₁*<*L₂.* In the present disclosure, the length *L₁* of the first reflective branch 81 refers to a length of a part of the silicon substrate 1 located in the P-type doped region and protruded from the sidewall 9 of the P-type doped region. The length *L₂* of the second reflective branch 82 refers to a length of a part of the P-type doped layer 2 protruded from the sidewall 9 of the P-type doped region. That is, the first reflective branch 81 is the part of the silicon substrate 1 located in the P-type doped region and protruded from the sidewall 9 of the P-type doped region, and the second reflective branch 82 is the part of the P-type doped layer 2 protruded from the sidewall 9 of the P-type doped region. By controlling *L₁ < L₂*, the first reflective branch 81 can be prevented from obstructing the reflected light from the second reflective branch 82, thereby enhancing the multiple utilizations of light between the first reflective branch 81 and the second reflective branch 82.

In some embodiments of the present disclosure, 0.5 µm≤*L₁*≤1 µm, and 1 µm≤*L₂*≤2 µm. For example, *L₁* is 0.5 µm, 0.6 µm, 0.8 µm, or 1 µm, and *L₂* is 1 µm, 1.2 µm, 1.5 µm, 1.8 µm, or 2 µm.

In some embodiments of the present disclosure, referring to FIG. 4, the sidewall 9 of the isolation channel adjacent to the P-type doping region is inclined towards the P-type doped region at an angle α of 40° to 60°. For example, the angle α is 40°, 45°, 50°, 55°, or 60°. As such, the light is enabled to be reflected and refracted multiple times between the inclined surface of the sidewall, the first reflective branch, the second reflective branch, and the first textured structure, thereby increasing the optical path of light on the back side of the solar cell, which is beneficial for increasing the light absorption by the silicon substrate and consequently enhancing the light utilization on the back side of the solar cell.

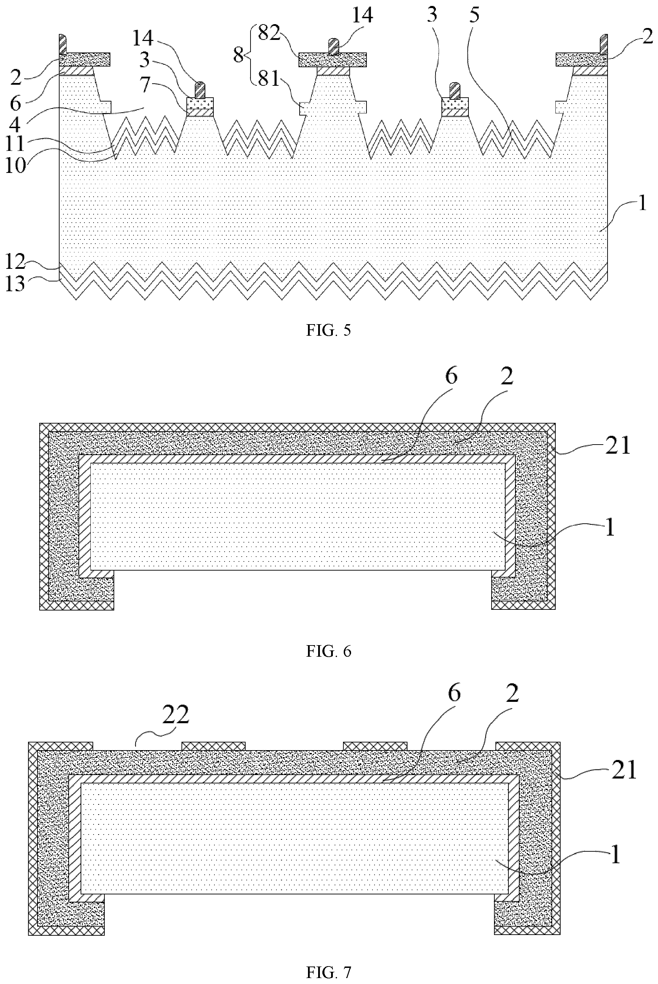

In some embodiments of the present disclosure, referring to FIG. 5 which is a schematic structural view of a solar cell according to another embodiment of the present disclosure, the back side of the silicon substrate 1 is also sequentially provided with a first passivation layer 10 and a first anti-reflection layer 11 in the isolation channel 4. The front side of the silicon substrate 1 is provided with a second textured structure. The front side of the silicon substrate 1 is sequentially provided with a second passivation layer 12 and a second anti-reflection layer 13. In addition, an electrode grid line 14 is further provided in each of the P-type doping region and the N-type doping region.

In the present disclosure, a preparation method of the solar cell can be as follows:
First polishing treatment: the silicon substrate is etched and polished using a mixed solution of an alkaline solution and a pre-polishing additive for the purpose of removing scratches and oil stains. The alkaline solution can be a NaOH solution or a KOH solution. An alkali concentration of the alkaline solution is in a range of 0.5 wt% to 5 wt%. A processing temperature is a range of 60 °C to 80 °C. A polishing time is in a range of 200 s to 800 s. After the polishing is completed, the silicon substrate is cleaned with a mixed solution containing hydrofluoric acid (at a concentration range of 1 wt% to 6 wt%) and hydrochloric acid (at a concentration range of 1.5 wt% to 5 wt %), followed by cleaning with deionized water and oven-drying. The pre-polishing additive can be a commercially available pre-polishing additive, which is not specifically limited in the present disclosure as long as the purpose of the present disclosure can be achieved.

First deposition treatment: through a low-pressure chemical vapor deposition (LPCVD) method, a first dielectric layer and an intrinsic amorphous silicon layer are sequentially deposited on the back side of the silicon substrate, wherein the first dielectric layer has a thickness range of 0.5 nm to 3 nm, the intrinsic amorphous silicon layer has a thickness of 100 nm to 300 nm, and a deposition temperature in the LPCVD is in a range of 550 °C to 650 °C. Then the intrinsic amorphous silicon layer of the half-finished solar cell is doped through a thermal diffusion method, with, for example, BCl₃ as a doping source, to obtain a P-type doped layer with a thickness range of 200 nm to 400 nm, and a first silicon oxide mask layer with a thickness range of 20 nm to 60 nm is formed on a surface of the P-type doped layer. The structure of the half-finished solar cell obtained after the first deposition treatment is shown in FIG. 6, with the first dielectric layer 6, the P-type doping layer 2, and the first silicon oxide mask layer 21 being subsequently disposed on the back side of the silicon substrate 1.

First patterning treatment: the half-finished solar cell is subjected to the first patterning treatment through a laser scanning to form a patterned region, with an impact depth of the patterning treatment being greater than or equal to the thickness of the first silicon oxide mask layer. The laser-related parameters in the present disclosure can be as follows: the laser is of a type of at least one of nanosecond laser, picosecond laser, or femtosecond laser; the laser light source is of a type of any one of infrared laser light, visible laser light, and ultraviolet laser light; the laser has an energy density range of 30 mJ/cm² to 3000 mJ/cm² and a wavelength range of 700 nm to 1000 nm; and the laser spot can have a circular shape or a square shape. The structure of the half-finished solar cell obtained after the first patterning treatment is shown in FIG. 7, with the patterned region 22 being formed.

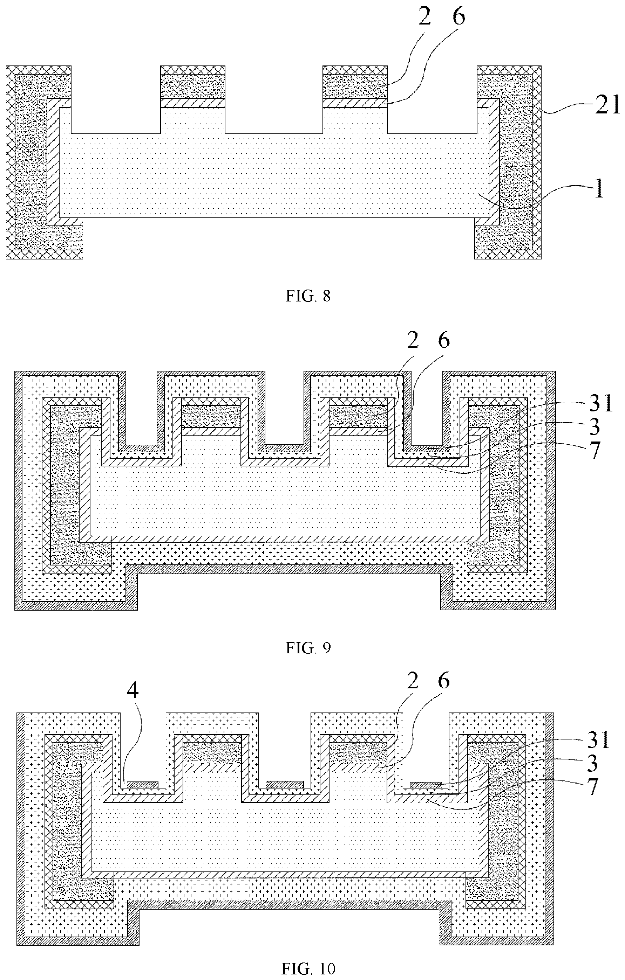

Second polishing treatment: the half-finished solar cell is subjected to alkaline cleaning with a mixed solution of an alkaline solution and a post-polishing additive, allowing the patterned region 22 to be etched down to the silicon substrate 1, while the non-patterned region remains unetched due to the protection provided by the first silicon oxide mask layer 21. The alkaline solution can be a NaOH solution or a KOH solution. An alkali concentration of the alkaline solution is in a range of 0.5 wt% to 5 wt%. A processing temperature is in a range of 60 °C to 80 °C. A polishing time is in a range of 200 s to 600 s. The post-polishing additive mainly contains sodium gluconate, a protective agent, a brightener, etc. The post-polishing additive can be a commercially available post-polishing additive. Exemplarily, the post-polishing additive is a post-polishing additive of a model BPL719. After the polishing is completed, the half-finished solar cell is subjected to alkaline cleaning with an alkaline solution, cleaning with water, and acid cleaning with an acid solution, and subjected to processes such as cleaning with water and oven-drying for use. The structure of the half-finished solar cell obtained after the second polishing treatment is shown in FIG. 8.

Second deposition treatment: through an enhanced plasma chemical vapor deposition (PECVD) method, a second dielectric layer and a second doped amorphous silicon layer are sequentially grown on the patterned region, the non-patterned region, and side edges on the back side of the half-finished solar cell obtained after the second polishing treatment, and a second silicon oxide mask layer with a thickness range of 20 nm to 60 nm is formed on a surface of the second doped amorphous silicon layer, with the doping type of the second doped amorphous silicon layer opposite to that of the first doped layer. Meanwhile, the doped amorphous silicon in the second doped amorphous silicon layer is crystallized and converted into the doped polysilicon in a high temperature atmosphere (at a temperature of 700 °C to 900 °C) to form a second doped layer. The structure of the half-finished solar cell obtained after the second depositing treatment is shown in FIG. 9A, with the second dielectric layer 7, the N-type doped layer 3, and the second silicon oxide mask layer 31 being sequentially formed on the back side of the silicon substrate.

Second patterning treatment: the half-finished solar cell obtained after the second depositing treatment is subjected to the second patterning treatment through a laser scanning method. The second silicon oxide mask layer is removed from the patterned region by laser and the patterned second doped layer is formed. The laser-related parameters in the present disclosure can be as follows: the laser is of a type of at least one of nanosecond laser, picosecond laser, or femtosecond laser; the laser light source is of a type of any one of infrared laser light, visible laser light, and ultraviolet laser light; the laser has an energy density range of 30 mJ/cm² to 3000 mJ/cm² and a wavelength range of 700 nm to 1000 nm; and the laser spot is of quadrangular-shaped with a size of (20 to 400) µm × (20 to 400) µm. The structure of the half-finished solar cell obtained after the second patterning treatment is shown in FIG. 10, with the patterned P-type doped layer 2, the N-type doped layer 3, and an isolation channel 4 being formed on the back side of the silicon substrate, and the respective silicon oxide mask layers being remained on the surfaces of the P-type doped layer 2 and the N-type doped layer 3.

Texturing: the wrap-around depositing layers are removed from the half-finished solar cell through a single-sided acid polishing, and the half-finished solar cell is textured using a mixed solution including a texturing additive and NaOH to form a first textured structure in a surface of the silicon substrate in the isolation channel 4 on the back side of the half-finished solar cell and form a second textured structure in a surface of the silicon substrate on the front side of the half-finished solar cell at a processing temperature range of 60 °C to 85 °C for a reaction time ranging from 300 s to 800 s. The texturing additive is of a model of ZRY00B. In the mixed solution, a mass concentration of the texturing additive is in a range of 1% to 3%, and a mass concentration of NaOH is in a range of 0.5% to 2%. The texturing additive includes carboxymethyl cellulose, a defoamer, and sodium lignin sulfonate, with a mass concentration of the carboxymethyl cellulose ranging from 1% to 2%, a mass concentration of the defoamer ranging from 1% to 2%, and a mass concentration of the sodium lignin sulfonate ranging from 0.5% to 2%. Then, the half-finished solar cell is sequentially subjected to alkaline cleaning with an alkaline solution, water cleaning, and acid cleaning with an HF acid solution, and subjected to processes such as cleaning with water and drying.

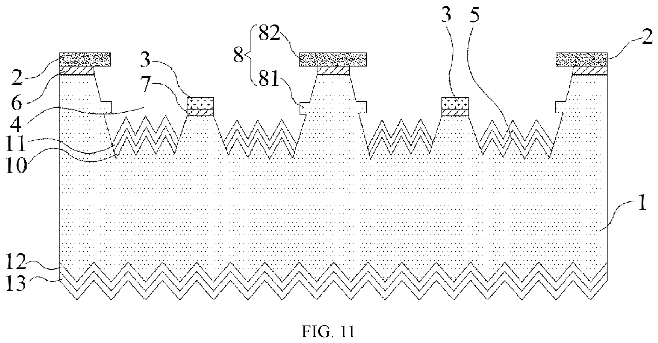

Preparation of functional layers: after removing the silicon oxide mask layers on the surfaces of the P-type doped region and the N-type doped region, through PECVD, aluminum oxide layers are respectively deposited as passivation layers on the front side and the back side of the half-finished textured solar cell, and then silicon nitride layers are respectively deposited as anti-reflection layers on the surfaces of the aluminum oxide passivation layers, wherein referring to FIG. 11, the first passivation layer 10 has a thickness range of 3 nm to 8 nm, the first anti-reflection layer 11 has a thickness range of 60 nm to 90 nm, the second passivation layer 12 has a thickness range of 3 nm to 8 nm, and the second anti-reflection layer 13 has a thickness range of 80 nm to 110 nm.

Preparation of electrode grid lines: on the back side of the half-finished solar cell with the functional layers, the electrode paste is printed onto the P-type doped region and the N-type doped region by screen printing and then sintered to form the electrode grid lines 14 as shown in FIG. 5.

The manner of forming the first reflective branch and the second reflective branch is not specifically limited in the present disclosure, as long as the purpose of the present disclosure can be achieved. Exemplarily, the second reflective branch can be formed through the above-mentioned second patterning treatment during which the laser is controlled to have an energy density of 30 mJ/cm² to 3000 mJ/cm² and a wavelength of 700 nm to 1000 nm and the laser spot is controlled to have a quadrangular shape with a size of (20 to 400) µm × (20 to 400) µm, in combination with the above-mentioned texturing process during which the reaction time is in a range of 300 s to 800 s and the processing temperature is in a range of 60 °C to 85 °C. The first reflective branch can be formed through the above-mentioned first patterning treatment during which the laser is controlled to have an energy density of 30 mJ/cm² to 3000 mJ/cm² and a wavelength of 700 nm to 1000 nm, in combination with the above-mentioned texturing process. In the texturing process, the mixed solution of the NaOH solution and the additive including carboxymethyl cellulose at a mass concentration of 1% to 2%, a defoamer at a mass concentration of 1% to 2%, sodium lignin sulfonate at a mass concentration of 0.5% to 2%, sodium gluconate at a mass concentration of 1% to 2%, and a brightener at a mass concentration of 0.5% to 1% is used for reaction. In the mixed solution, a mass concentration of the texturing additive is in a range of 1% to 3%, and a mass concentration of NaOH is in a range of 0.5% to 2%. A reaction time is in a range of 300 s to 800 s, and a processing temperature is in a range of 60 °C to 85 °C.

The present disclosure further provides a photovoltaic module, which includes the solar cell described in any of the above embodiments.

The present disclosure further provides a photovoltaic module, which is used to convert received light energy into electrical energy and transport the electrical energy to an external load. The photovoltaic module includes: at least one cell string formed by connecting a plurality of solar cells as described above; a packaging adhesive film configured to cover the surface of the cell string; and a cover plate configured to cover the surface of the packaging adhesive film facing away from the cell string.

## Claims

1. A solar cell, comprising a silicon substrate (1), wherein a back side of the silicon substrate comprises a P-type doped region (20) and an N-type doped region (30) that are alternately arranged, the P-type doped region corresponds to a P-type doped layer (2) disposed on the back side of the silicon substrate, and the N-type doped region corresponds to an N-type doped layer (3) disposed on the back side of the silicon substrate, an isolation channel (4) is provided between the P-type doped region and the N-type doped region adjacent to each other, and a bottom surface of the isolation channel is provided with a first textured structure (51);
wherein a height difference between the P-type doped layer and the first textured structure is defined as *H₁*, a height difference between the N-type doped layer and the first textured structure is defined as *H₂*, and *H₁*>*H₂*; and
wherein a sidewall of the isolation channel adjacent to the P-type doped region is provided with at least two reflective branches (8).

2. The solar cell according to claim 1, wherein 1.5 µm ≤ *H₂* ≤ 5 µm, and 1.5 ≤ *H₁*/*H₂* ≤ 3.5.

3. The solar cell according to claim 1 or 2, wherein the at least two reflective branches are configured to redirect light reflected from the back side of the silicon substrate back into the silicon substrate.

4. The solar cell according to any one of claims 1 to 3, wherein the at least two reflective branches are each protruded from the sidewall of the isolation channel adjacent to the P-type doped region.

5. The solar cell according to any one of claims 1 to 4, wherein the at least two reflective branches comprise a first reflective branch (81) and a second reflective branch (82), and both the first reflective branch and the second reflective branch are located on a sidewall (9) of the isolation channel adjacent to the P-type doped region.

6. The solar cell according to claim 5, wherein a height difference between the second reflective branch and the first reflective branch is defined as *H₃*, and 1.5 µm ≤*H₃*≤ 3 µm.

7. The solar cell according to claim 5 or 6, wherein a length of the first reflective branch is defined as *L₁*, a length of the second reflective branch is defined as *L₂ ,* and *L₁ < L₂.*

8. The solar cell according to claim 7, wherein 0.5 µm ≤ *L₁* ≤ 1 µm, and 1 µm ≤ *L₂* ≤ 2 µm.

9. The solar cell according to any one of claims 5 to 8, wherein the sidewall of the isolation channel adjacent to the P-type doping region is inclined towards the P-type doping region, and the sidewall of the isolation channel adjacent to the P-type doping region, the first reflective branch, the second reflective branch, and the first textured structure are configured to enable light to be reflected and refracted therebetween multiple times.

10. The solar cell according to any one of claims 5 to 9, wherein the first reflective branch is a part of the silicon substrate protruded from the sidewall of the isolation channel.

11. The solar cell according to any one of claims 5 to 10, wherein the second reflective branch is a part of the P-type doped layer protruded from the sidewall of the isolation channel.

12. The solar cell according to any one of claims 1 to 11, wherein the sidewall of the isolation channel adjacent to the P-type doping region is inclined towards the P-type doping region at an angle of 40° to 60°.

13. The solar cell according to any one of claims 1 to 12, wherein the back side of the silicon substrate is provided with a first dielectric layer (6) in the P-type doped region and a second dielectric layer (7) in the N-type doped region, the P-type doped layer is disposed on a surface of the first dielectric layer facing away from the silicon substrate, and the N-type doped layer is disposed on a surface of the second dielectric layer facing away from the silicon substrate;
optionally, the first dielectric layer or the second dielectric layer has a thickness ranging from 0.1 nm to 5 nm;
optionally, the first dielectric layer or the second dielectric layer is made of a material selected from silicon oxide, magnesium fluoride, amorphous silicon, polysilicon, silicon carbide, silicon nitride, silicon oxynitride, aluminum oxide, titanium oxide, and any combinations thereof.
optionally, the silicon substrate has a thickness ranging from 100 µm to 200 µm.

14. The solar cell according to any one of claims 1 to 13, wherein the back side of the silicon substrate is further sequentially provided with a first passivation layer (10) and a first anti-reflection layer (11) in the isolation channel;
optionally, an electrode grid line (14) is further provided in each of the P-type doping region and the N-type doping region;
optionally, the front side of the silicon substrate is provided with a second textured structure, and a second passivation layer (12) and a second anti-reflection layer (13) are sequentially disposed on the front side of the silicon substrate.

15. A photovoltaic module, comprising the solar cell according to any one of claims 1 to 14.
